# EUROPEAN PATENT APPLICATION

(11) **EP 1 962 350 A1**
(43) Date of publication of application: **27.08.2008**
(21) Application number: 07102900.3
(22) Date of filing: 22.02.2007
(51) Int. Cl.: H01L 33/00

(54) **Emitting surface of light emitting diode packages**

(71) Applicant: LEXEDIS Lighting GmbH, 8380 Jennersdorf (AT)
(72) Inventor: Tasch, Stefan, 8380 Jennersdorf (AT); Derkits, Christian, 7535 St. Michael (AT); Chelly, Nader, Dunajska Streda 929 01 (SK)
(74) Representative: Rupp, Christian

(57) **Abstract**

A LED package comprises:
- a LED chip (1) mounted on a housing, and
- an essentially transparent layer (2) on top of the LED chip (1),

the transparent layer (2) having an essentially flat light exit surface (4).

The light exit surface (4) is provided with a plurality of microstructures (5) distributed over the plane of the light exit surface (4).

The microstructures (5) are geometrically designed for enhancing the light exit by the microstructures (5) offering differing angles for light rays from the interior of the transparent layer (2).

## Description

The present invention generally relates to the field of light-emitting semiconductors. The invention particularly relates to LED packages having a LED chip on top of which an essentially transparent layer is placed.

The present invention particularly targets at an improvement of the light exit at the emitting surface of the transparent layer.

This has to be seen in contrast to techniques for improving the light out put on chip level. E.g. US 6980710 proposes to pattern an optical microstructure immediately on top of a mass produced light-emitting device, such as a light emitting diode (LED), a vertical cavity surface emitting laser (VCSEL) or a photo detector, for the purpose of efficient coupling of light to or from the active region of the light-emitting device.

US 6924160 teaches a manufacturing method of organic flat light-emitting devices includes the following steps. First, a transparent substrate is provided, which has several microstructures on its first surface and the microstructures have a maximum height of 100 µm from the first surface. Second, a transparent anode is formed on the second surface of the transparent substrate that is opposite to the first surface. Thirdly, at least one organic electro-luminescent layer is formed on the transparent anode. Finally, a metal cathode is formed on the organic electro-luminescent layer

US 5779924 proposes a method for the fabrication of semiconductor light-emitting devices having at least one ordered textured interface (again, on chip level). Controlled interface texturing with an ordered pattern is provided on any or all interfaces of such a device to enhance light extraction from these interfaces and thus improve the performance of the device.

Also US 6649939 seeks to improve the light output of a light-emitting diode. The LED has at least one section of a light exit-side surface covered with a plurality of truncated pyramids. Light radiations, which are emitted by a light-generating layer, enter into the truncated pyramids through a base area and are efficiently coupled out of the side walls of the pyramids.

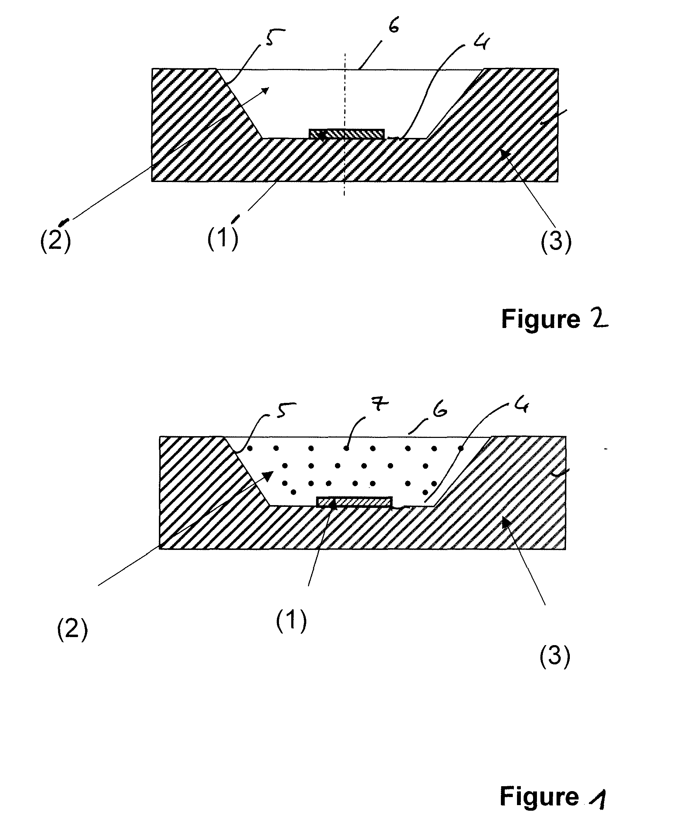

Figure 1 shows a known LED device containing a LED chip 1 emitting e.g. blue light. Above the LED chip 1 an essentially transparent layer 2 is arranged which can comprise wavelength-converting substances, such as for example phosphorous materials.

In the shown example the LED chip 1 is mounted in a recession 4 of a substrate 3.

The recession can have reflecting, inclined walls 5 directing light to an light exit surface 6 of the LED package by reflection.

The reference numeral 7 designates the colour conversion substance and/or particles. Figure 1 thus shows an example for a white LED device.

Figure 2 shows an example for a known monochromatic LED device having a monochromatic LED chip 1' on top of which an essentially transparent resin 2' has been dispensed in order to fill, in a flashing manner, the cavity 4.

The colour conversion layer 2 of figure 1 converts parts of the photons from the LED chip in the photons of a longer wavelength to yield light of different colour.

The shown known LED packages of figures 1 and 2 are provided with essentially flat light emitting surfaces 6 without structuring. When using flat surfaces, if the incident angle of the light to the emitting surface 6 is rather small, many light rays will be totally reflected internally, such that they are 'trapped' in the layer 2, 2' and can not exit from the optical emitting surface 6.

It is the object of the present invention to improve the light exit at such surface 6. This is an object which is completely different with taking care of an efficient light exit from on a chip level itself.

This object is achieved by means of the features of the independent claims. The dependent claims develop further the central idea of the present invention.

According to the present invention, a LED package is proposed comprising the LED chip mounted on a housing. On top of the LED chip 1 an essentially transparent layer 2 is provided which optionally comprises colour conversion and/or scattering particles. The transparent layer has an essentially flat light exit surface. According to the invention the light exit surface is provided with a plurality of microstructures distributed over the plane of the light exit surface and such in a two-dimensional arrangement. The micro-structures are geometrically designed for enhancing the light exit in that the microstructures offer different angles for light rays coming from the interior of the essentially transparent layer.

Note that the microstructures represent a micro-texture of the light exit surface of the LED package.

The microstructures can have the shape of pyramids and/or truncated pyramids.

Alternatively or additionally the microstructures can have at least partially linear or concave base edges.

The microstructures can have the shape of hemispheric surfaces.

The microstructures can have a height, measured from the deepest edge to the peak, in the order of 10µm to 100µm, preferably 30 µm to 80µm.

The microstructures can cover a surface in a range from 2µm * 2µm to 300µm* 300µm.

The microstructures can cover an essentially square surface.

The microstructures can be arranged one next to each other. Alternatively, there can be a flat 'unstructured' area between two neighbouring microstructures.

The transparent layer can be made from a glass or a silicone.

The transparent layer can have a thickness of between 0.3mm and 2mm.

The transparent layer can have a diameter from between 0.5mm and 4mm.

The transparent layer can comprise colour conversion material and/or particulate scattering material.

The microstructures are obtainable by stamping, etching, pressing or laser-machining.

The microstructures can have an identical shape over the entire surface of the light emitting surface 6, or a shape which changes as a function of the radial position.

The microstructures of the light emitting surface can have an identical shape, but different dimensions.

The transparent layer can be dispensed in a cavity on the bottom of which is arranged the LED chip, which cavity can be provided with inclined walls.

The inclined wall can be coated with a reflective surface.

The microstructures can be arranged in a periodic order.

The microstructures can have dimensions which are substantially larger than the wavelength of the light emitted from the LED chip.

The microstructures can be provided in a separate structure layer on top of another transparent layer.

The invention also proposes a method for improving the light exit from a LED package by microstructuring the light exit surface of an essentially transparent layer dispensed above a LED chip.

Further features, advantages and objects of the present invention will become evident for the skilled person when going through the following detailed description of preferred embodiments of the invention.
- Fig. 1: shows schematically a known white LED package,
- Fig. 2: shows schematically a known monochromatic LED package,
- Fig. 3: shows schematically a LED package according to the present invention,
- Fig. 4: shows schematically a cross-sectional view of the LED package of Fig. 3,
- Fig. 5: shows schematically the light exit from a LED package having an unstructured (flat) light emitting surface,
- Fig. 6: shows schematically the improved light exit by microstructuring the light exit surface of the LED package,
- Fig. 7: shows schematically a LED package with separate microstructured surface layer on top of a colour conversion layer,
- Fig. 8: shows a microstructured layer being provided between two essentially transparent layers dispensed above the LED chip as well as an optional additional microstructured layer at the outer side of the light emitting surface,
- Fig. 9: shows the detailed view of a possible implementation of the microstructures, and
- Fig. 10: shows an alternative example, in a detailed view, of microstructures according to the present invention.

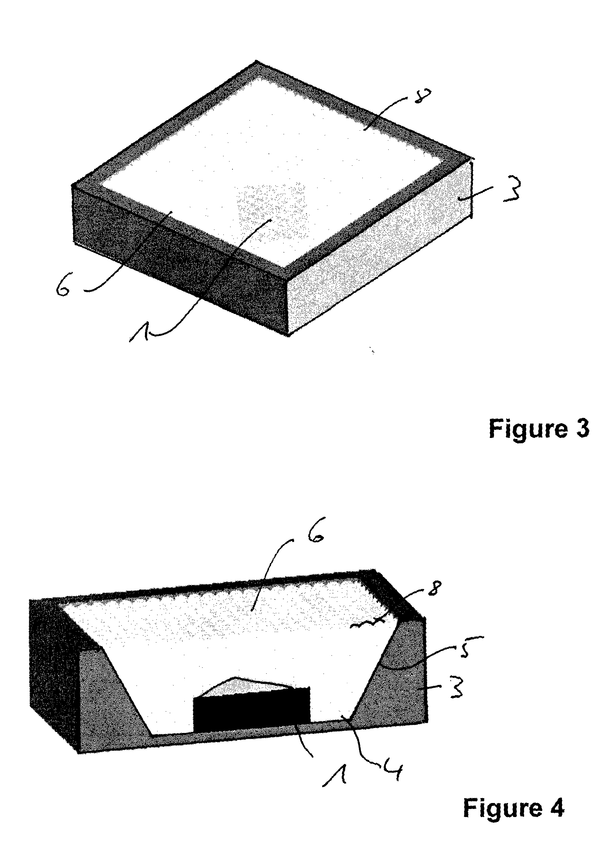

Schematically an essentially square LED chip 1 is shown. Also schematically it is indicated that the light exit surface 6 (see also figure 4) is provided with microstructures distributed in a regular pattern over the entire surface of the light exit surface 6.

It has been found that due to such a microstructuring of surfaces, a more efficient light exit is achieved.

The term "microstructuring" indicates that the dimensions are much smaller than the structures necessary for achieving a Fresnel effect.

Contrary to Fresnel lenses the microstructures according to the invention are periodic in over the length and width of the light exit surface. Thus the microstrucures are distributed in a periodic grid arrangement (regular pattern).

Preferably each microstructure offers at least two differently oriented, inclined (i.e. not vertical nor horizontal) planes or tangent for incident light.

Preferably the microstructures simply refract the light. They do not scatter the light nor change the polarisation or spectrum of the light.

Preferably each individual microstructures tapers toward its peak are.

According to the known light emitting surfaces, which are not always hemispheric but usually flat, the incident angle of the light to the surface is small (and thus potentially smaller than the critical incident angle where total internal reflection appears. This causes a lot of losses by total internal reflection.

The microstructuring of the surface according to the present invention improves the light extraction, the colour uniformity and the direction of the emission angle.

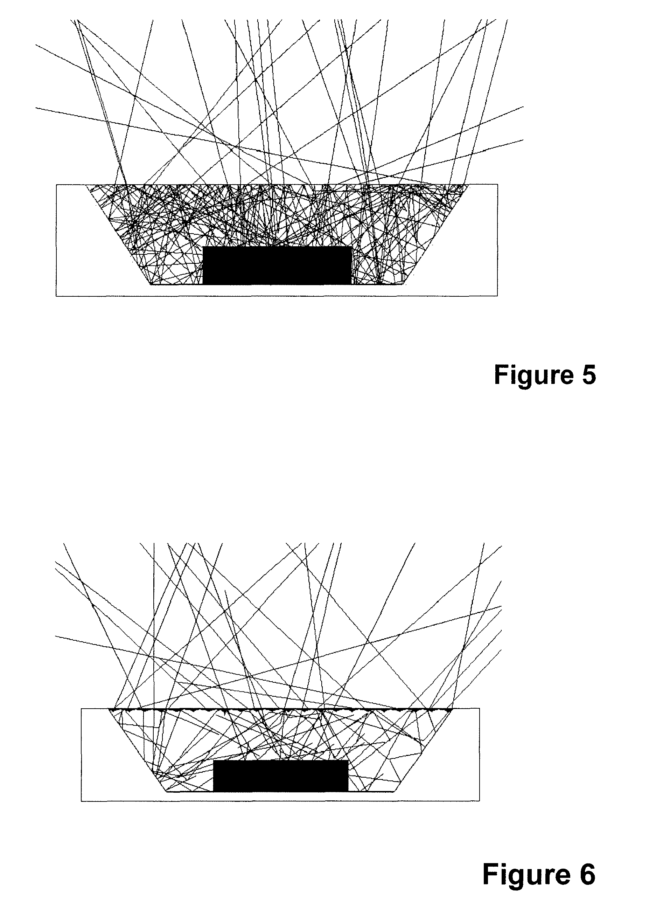

Figure 5 demonstrates this effect when being compared with the examples of figures 6 representing the invention.

It is assumed that microstructures having dimensions in the order of the wavelength of the emitted light from the LED chip 1 or preferably substantially larger offer different incident angles for the light coming from the LED chip or generally from the interior of the transparent layer thus reducing the total reflection rate.

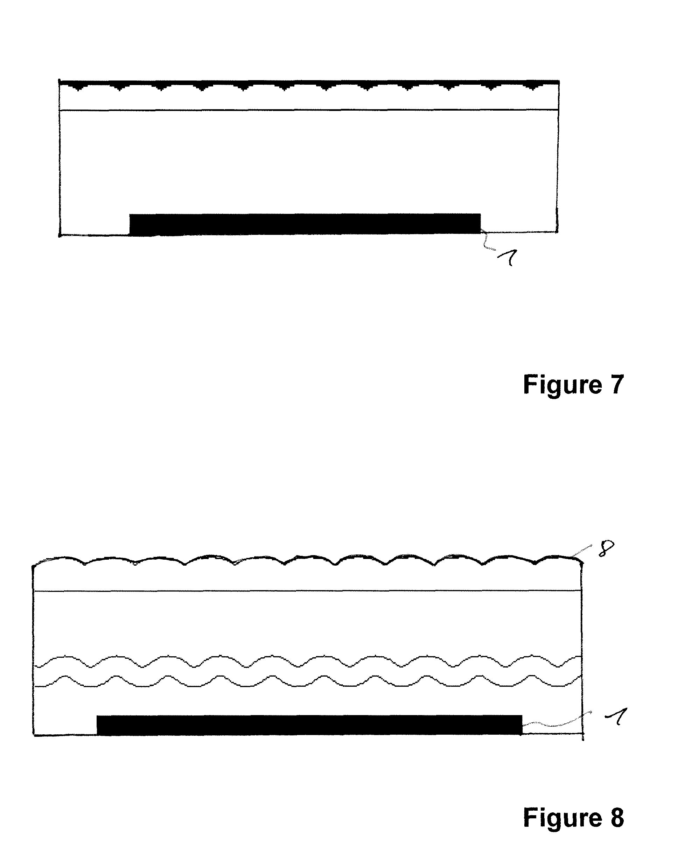

As shown in figure 7, the light emitting surface can be microstructured and can be applied as a separate layer on the essentially transparent layer surrounding the chip 1.

As is illustrated in figure 8, a microstructured layer can be provided between a first transparent layer and a second transparent layer. Alternatively, an additional microstructured layer can be arranged on top of the second essentially transparent layer.

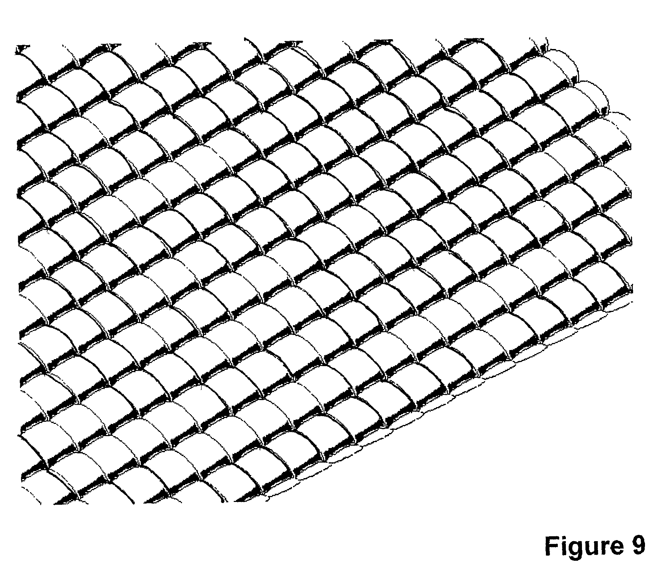

Figure 9 shows a detailed view of microstructures, which are essentially parts of hemispheres and which are arranged one next to each other.

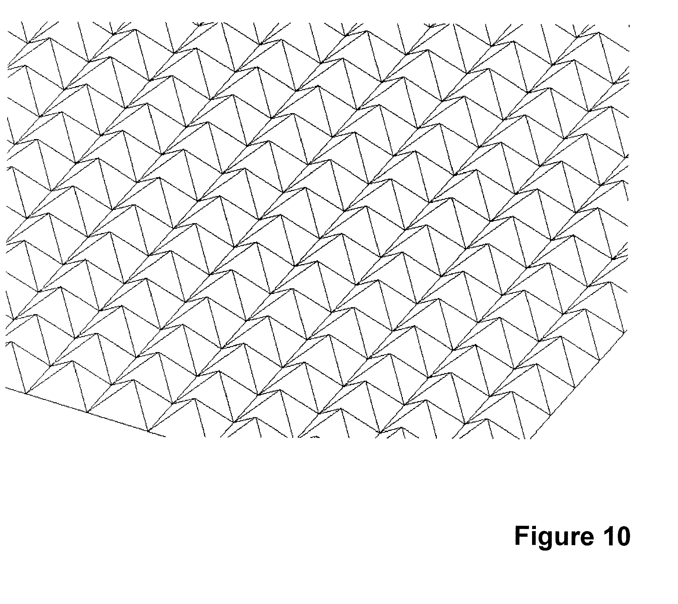

Figure 10 shows an alternative embodiment, i.e. pyramids. Alternatively, also truncated pyramids or pyramids having changing pitches over the height can be used.

While the pyramids of figure 10 will have linear base edges, the hemispheric surfaces of figure 9 are examples for microstructures having concave base edges.

Preferably the microstructures have a height, when measured from their deepest valley to the peak, in the order of 10 µm to 100µm, preferably 30µm to 80µm.

Each individual microstructure can cover an essentially square surface in the range of e.g. 2µm * 2µm to 300µm * 300µm.

The microstructures can be formed (machined) in a glass or silicone material.

The transparent layer can have a thickness of between 0.3mm and 2mm. The transparent layer can have a diameter e.g. between 0,5 mm and 4mm.

The microstructures can e.g. be manufactured by stamping, edging, pressing or laser-machining.

According to a preferred embodiment, the shape of the microstructures changes as a function of their radial position, measured from the center of the LED package.

The microstructures can have all identical shapes and dimensions or alternatively can have identical shapes but different dimensions.

In the example of figure 4, the light exit rate is deteriorated due to the reflective side walls and the flat emitting surface, such that the light rays will be mirrored often between the side walls and flat extracting surface. Every time a ray hits a reflective surface, a part of the energy is absorbed. Thus, the losses increase with the number of fitting a surface before leaving the LED package.

In contrast thereto, as shown in figure 6, the number of reflections inside the LED package are reduced such that more rays with lower losses can exit from the emitting surface.

In the example of figure 7, the microstructured surface can be a transparent layer arranged on top of a colour conversion layer.

Preferably the microstructures are stamped into the emitting surface of the LED package during a curing process of the refused material (silicone, etc.). Alternatively or additionally the light emitting surface can be finally machined with a material-reducing process such as for example lasering.

A stamping process can be used taking place after the dispension of the layer to be microstructured.

The hemispheric microstructures according to figure 9 preferably have a height, when measured from the valley the peak, of about 30µm to 80µm. The hemispheric microstructures offer a plurality of non-vertical and non-horizontal tangents to incident light.

Pyramids or truncated pyramids as shown in figure 10 preferably have a height, when measured from the valley to the peak, of about 50µm to 100µm. The pyramid-shaped microstructures respectively offer two non-vertical and non-horizontal planes to incident light.

## Claims

1. A LED package, comprising:
- a LED chip (1) mounted on a housing, and
- an essentially transparent layer (2) on top of the LED chip (1),
the transparent layer (2) having an essentially flat light exit surface (4),
which light exit surface (4) is provided with a plurality of quasi-periodic microstructures (5) distributed over the plane of the light exit surface (4),
which microstructures (5) are geometrically designed for enhancing the light exit by the microstructures (5) offering differing angles for light rays from the interior of the transparent layer (2).

2. A LED package, comprising:
- a LED chip (1) mounted on a housing, and
- a coating (2) on top of the LED chip (1),
the coating layer (2) having an essentially flat light exit surface (4) containing colour conversion particles and optional scattering particles
which light exit surface (4) is provided with a plurality of quasi-periodic microstructures (5) distributed over the plane of the light exit surface (4),
which microstructures (5) are geometrically designed for enhancing the light exit by the microstructures (5) offering differing angles for light rays from the interior of the transparent layer (2).

3. The LED package according to claim 1 or 2,
wherein the microstructures (5) have the shape of pyramids or truncated pyramids.

4. The LED package according to any of the preceding claims,
wherein the microstructures (5) have linear or concave base edges.

5. The LED package according to claim 1 or 2,
wherein the microstructures (5) have the shape of hemispheric surfaces.

6. The LED package according to any of the preceding claims,
wherein the microstructures (5) have a height, measured from their deepest edge to the peak, in the order of 10µm to 100µm, preferably 30µm to 80µm.

7. The LED package according to any of the preceding claims,
wherein the microstructures (5) respectively cover a surface in from 2µm * 2µm to 300µm * 300µm.

8. The LED package according to any of the preceding claims,
wherein the microstructures (5) cover an essentially square surface.

9. The LED package according to any of the preceding claims,
wherein the microstructures (5) are arranged one next to each other.

10. The LED package according to any of the preceding claims,
wherein the transparent layer (2) is made from a glass or a silicone.

11. The LED package according to any of the preceding claims,
wherein the transparent layer (2) has a thickness of between 0.3 mm and 2mm.

12. The LED package according to any of the preceding claims,
wherein the transparent layer (2) has a diameter from between 0.5mm and 4mm.

13. The LED package according to any of the preceding claims,
wherein the transparent layer (2) comprises a color-converting material.

14. The LED package according to any of the preceding claims,
wherein the transparent layer (2) comprises a particulate scattering material.

15. The LED package according to any of the preceding claims,
wherein the microstructures (5) are manufactured by stamping, etching, pressing or laser-machining.

16. The LED package according to any of the preceding claims,
wherein the microstructures (5) have a shape which changes as a function of the radial position.

17. The LED package according to any of the preceding claims,
wherein the microstructures (5) have identical shapes, but differing dimensions.

18. The LED package according to any of the preceding claims,
wherein the transparent layer (2) is filled in a cavity on the bottom of which is arranged the LED chip (1) and which is provided with inclined walls.

19. The LED package according to claim 18,
wherein the inclined surfaces are coated wit ha reflective coating.

20. The LED package according to any of the preceding claims,
wherein the microstructures (5) are arranged in a periodic order.

21. The LED package according to any of the preceding claims,
wherein the microstructures (5) have dimension larger than the wavelength of the light emitted from the LED chip (1).

22. The LED package according to any of the preceding claims,
wherein the microstructures (5) are provided in a separate structure layer (2) on top of another transparent layer (2).

23. A method for improving the light exit from a LED package, the LED package comprising:
- a Led chip (1) mounted on a housing, and
- an essentially transparent layer (2) on top of the LED chip (1),
the transparent layer (2) having an essentially flat light exit surface (4),
comprising the step of
providing the light exit surface (4) with a plurality of periodic microstructures (5) distributed over the plane of the light exit surface (4),
which microstructures (5) enhance the light exit by the microstructures (5) offering differing angles for light rays from the interior of the transparent layer (2).

24. The method according to claim 23,
wherein the microstructures (5) are manufactured by stamping, etching, pressing or laser-machining.
